# EUROPEAN PATENT APPLICATION

(11) **EP 4 321 837 A1**
(43) Date of publication of application: **14.02.2024**
(21) Application number: 22306205.0
(22) Date of filing: 10.08.2022
(51) Int. Cl.: G01B 11/24, G01N 21/952, G01R 31/12, G06T 7/00

(54) **METHOD FOR DETERMINING A QUALITY OF A CABLE SURFACE**

(71) Applicant: Nexans, 92400 Courbevoie (FR)
(72) Inventor: DOEDENS, Espen, 1788 HALDEN (NO)
(74) Representative: Ipsilon

(57) **Abstract**

A method for determining a quality of a surface of a cable, a part of a cable or an accessory for a cable comprises capturing and storing a set of 3-dimensional (3D) surface geometry measurement data of an area of interest of a surface of the cable or cable component by moving a 3D surface scanner about the cable over the area of interest. In an analysis unit, then create a continuous 3D surface geometry measurement of the area of interest by processing measurement data from the 3D surface scanner. The processing comprises identifying anomalies in the continuous 3D surface geometry and inspect the captured 3D surface geometry measurement data to discover sub-areas with increased probability for faults. A quality report for the scanned surface is provided.

## Description

### Technical field

The present invention relates to high voltage and medium voltage cables, in particular to a method for inspecting surfaces and/or interfaces of high voltage and/or medium voltage cable components.

### Background

A high voltage (HV) and medium voltage (MV) cable is used for electric power transmission at medium and high voltage, e.g. above 1000 V. Such cables include a conductor and an insulation. The insulation may consist of polymers or polyethylene, including ethylene propylene rubber (EPR) and cross-linked polyethylene (XLPE). At inner and outer sides of the insulation semiconducting layers are fused to the insulation. The semiconducting layers prevent air-filled cavities between the metal conductors and the dielectric so that small electric discharges cannot arise and endanger the insulation material. The insulation is usually also covered by a copper or aluminum wire screen, or a lead or aluminium or copper jacket, or combinations thereof. This metallic screen or jacket is followed by a polymeric (e.g. PE or PVC) outer sheath.

The cables are manufactured in cable manufacturing lines using extrusion. The quality control and meeting product specifications are very important in cable production. A failure due to dielectric breakdown in the HV-cable may cause an outage to power supply. For instance, high voltage cables are used for long length connections for power distribution and power transmission. The manufacturing quality is monitored during the operation of the cable manufacturing line to assure the quality of the final product. The final product is usually an assembly comprising cable lengths connected together as well as connected accessories such as terminations, GIS terminations, asymmetric joints, HV or MV joints, MV terminations, MV plugin terminations, etc.

Traditional quality control in the High voltage industry involves inspection by the human eye, which does not represent a fool-proof solution. Other may include some form of electrical testing requiring HV energization of the component, such as PD testing.

EP3901571 discloses a system and a method for determining a quality of a surface of a high voltage cable end using a 3D scanner. The method comprises moving a non-contact surface scanner about the cable end, measuring distance to the surface over the area of the surface by sequentially measuring a plurality of sub-areas of the area of the surface, creating a continuous 3D surface geometry measurement of the surface of the cable end and comparing, using the continuous 3D surface geometry measurement with at least one surface geometry acceptance threshold determining the quality of the surface of the high voltage cable end.

Such 3D scanning methods leads to a large amount of data which is processed and can be used for controlling and monitoring the quality of various HV and MV cables, cable parts and/or accessories. However, the large amounts of data takes time to process and also require large processor capacity and computer performance. Further, there will possibly be increasing wishes for resolution and accuracy in the 3D surface geometry data in order to increase the quality of the cables/cable parts/accessories.

Further, pre-molded stress cones, pre-molded joints, and other pre-molded components used in MV and HV applications (AC and DC) typically comprise of both insulative and semiconductive layers. The electrical strength and long-term performance of these components relies on the interfacial quality in between the semiconductive and insulative layers, as well as the interface between the component and the cable it is installed onto. Typically, in prior art, quality is assessed by means of AC withstand tests, PD measurements and (for DC) also DC withstand tests. Such tests ensure the electrical quality, by means of quality control (QC), though their ability to effectively screen for any kind of manufacturing defect can be questioned.

The present, aforementioned testing methodology of these accessory components may struggle assessing the following defects:
- Macro-geometric deviation (e.g. overall 3D dimensions of the component)
- Cuts/defects on parts not submitted to high field stress during the QC
- Geometry of crucial interfacial regions may pass such QC despite of deviating from their original design.
- No possibility to perform QC on semiconductive parts (deflectors, center shields) that are later brought into the final mold where the insulative parts are injection molded.

Moreover, prior art electric test methods have a long feedback loop between QC and manufacturing itself, as, especially HV components, often must wait for long time before being tested (batchwise). Some HV components also can have a high scrap-rate during the electrical test.

Moreover, the present QC generates no geometric data that can be used to track the components dimensions during its life time (industry 4.0).

There is thus a need for methods that enhances the computations and increases accuracy, as well as enables rapid quality testing. When performing quality testing simultaneously to or short time after production, it is possible to provide feedback to the production process as well as improving the processing methods and algorithms.

Optimizing methods for processing data can also provide the possibility for automatization, which in turn will save time and money. For example can separate semiconductive or insulative parts be scanned before they are being brought into the final assembly, such as a cable, cable part or cable accessory. This allows for a screening amongst such parts to reveal if any defects/deviations exist. Thereafter, the finally finished part is scanned.

### Summary of the invention

In one aspect of the present invention it is provided a method for determining a quality of a surface of a cable, a part of a cable or an accessory for a cable.

In the following description, the term "cable part" is meant to comprise all the subelements which is assembled to form any kinds of HV and MV cables, parts of a cable and/or cable accessories.

A method for determining a quality of a surface of a cable, a part of a cable or an accessory for a cable , comprising following steps:
- capture and store a set of 3-dimensional, 3D, surface geometry measurement data of an area of interest of the surface of the cable or the part of a cable or the accessory for a cable by moving a 3D surface scanner over the area of interest,
- in an analysis unit, create a continuous 3D surface geometry measurement of the area of interest by processing the set of 3D surface geometry measurement data from the 3D surface scanner,
   - where the processing comprises identifying anomalies in the continuous 3D surface geometry and inspect the captured 3D surface geometry measurement data to discover sub-areas with increased probability for faults, and
- generate a quality report for the surface scanned by the 3D surface scanner.

In a last step, a quality report for the scanned surface is generated. The quality report may comprise results of calculations, an evaluation of if the cable part should be used or replaced, ie. a go/no go message, and may also comprise pictures of the surface of interest and/or other illustrations.

One example of illustrations can be a deviation map that identifying differences between the area of interest of a surface of the cable or cable component and a 3D drawing of the area of interest of the surface of the cable or cable part. This can for example be created by comparing the continuous 3D surface geometry measurement of the area of interest with the 3D drawing of the area of interest and mark the differences in the continuous 3D surface geometry measurement to produce such a a deviation map.

The method can also comprise identifying locations in the continuous 3D surface geometry measurement of the area of interest that lack data and/or comprise poor quality data. Such locations may for example be locations where a reference marker has been present, where a shadow has been cast by equipment, uneven movement of the surface scanner, etc. The method can then perform an interpolation calculation and use data from nearby data in to provide interpolated data which can be used to fill in the locations lacking data and/or comprising poor quality data.

To improve processing there can be identified locations in the continuous 3D surface geometry measurement of the area of interest that represents a curved cable part, and this part may be "straightened" by processing the data. The processing can for example comprise using a sine or cosine function on the data representing the curved cable part to change the representation of a curved cable part to a straightened cable part.

Similarly, locations in the continuous 3D surface geometry measurement of the area of interest that represents an oval cable part can be identified by using a sine or cosine function on the data.

The method can further comprise steps of
- sorting the identified anomalies by evaluating the predicted consequences of each anomaly,
- processing a subset of anomalies having the worst consequences by performing a finite element simulation to compute at least one of:
- local field enhancement into the insulation of the cable or the part of a cable or the accessory for a cable,
- maximum local voids,
- partial discharge inception voltage,
and use the results of the computations to calculate probability for faults.

The consequences can also comprise voltage if the surface was to be mated with the accessory body (over it) and the void is assumed to be air filled as a worst-case condition. (while in reality it will be filled with dielectric oil/grease).

Such calculations can comprise calculating local field enhancement factor, FEF, and local partial discharge inception voltage, PDIV.

Further steps of the method can comprise
- creating a training data set comprising the sub-areas with increased probability for faults, and
- training a fault detection algorithm in the analysis unit using the training data set.

As described above, cables, cable parts and cable accessories are constructed by using a number of sub-parts that are assembled to the final cable part. The method can be used to scan a surface of a sub-part of a cable part before assembling the cable part. In this way it is provided an image of the layers and construction of the cable part after assembly, which can be used to assess later faults, or can be used to compare with later scannings to evaluate wear of the cable part or to evaluate quality of a subsequent repair process.

The method may also comprise identifying differences between the area of interest of the surface of the cable or the part of a cable or the accessory for a cable and a 3D drawing of the area of interest of the surface of the cable or the part of a cable or the accessory for a cable by comparing the continuous 3D surface geometry measurement of the area of interest with the 3D drawing of the area of interest and mark the differences in the continuous 3D surface geometry measurement to produce a deviation map.

The method can also be used to provide feedback to an operator during the manufacturing of a cable, during a repair process or other processing of a cable part. The method can also be used shortly after such processing.

The scan data can in some embodiments map point distances as low as 100 um, thus enabling to screen for scratches, protrusions, defects, and the overall macro-geometric shape of each part.

The scan data can be further processed, for example using an algorithm dedicated to the specific part itself; which allows for specifying and using different defect tolerances in different regions, and tolerances on every 3D geometric feature of the part. The algorithm can also merge individual scan files of the parts and the final part to make a full 3D map of the component.

The algorithm may generate automatic quality reports and provide a go/no go message for the further use of the scanned component.

Machine learning between processed scanning results and the electrical test results can also be used to develop artificial intelligence (AI) that can be taught to predict the interfacial related electrical screening failures, thus enabling industry 4.0.

The scanned data can also be used at a later stage during the installation of the component, for example using laser scanning to control the positioning of the component as well as the cable end surfaces over which it is mounted. This allows for a creating 3D map of all interfaces within the entire cable part and/or assembly.

In some embodiments, the algorithms used can be updated, either by using AI as described, or by using previously scanned data to improve quality and update the algorithms at the locations where the scannings take place, for example by software updates over wireless communication.

Further embodiments may further improve capacity and quality of the scannings. Examples of embodiments are:
- The use of robot or fixture mounted scanner heads, allowing to automate the scanning process itself. Such scanner solutions can move the scanner head in preprogrammed manners, or in pre-defined mechanical motions.
- To use scanners where an external camera can track the scanners and the measurement objects 3D positions in the room, allowing for a scanning process with zero setup time as no 3D markers are needed to track the scanners position in relation to the test object.

The data, both raw data collected and/or processed data may be transmitted to a remote location, such as a remote computer, or a data cloud. The transmitted data can for example be accessed by the manufacturer, the cable owner or the operator in order to assess the quality of the cable part and/or to track the quality over time.
Fig. 1 illustrates an example of a 3D surface geometry measurement of a of a cable.
Fig. 2 illustrates a high volt cable end.
Fig. 3 illustrates a high voltage joint for a high voltage cable
Fig. 4 is a flow chart illustrating steps of a method for scanning a surface of a cable part.

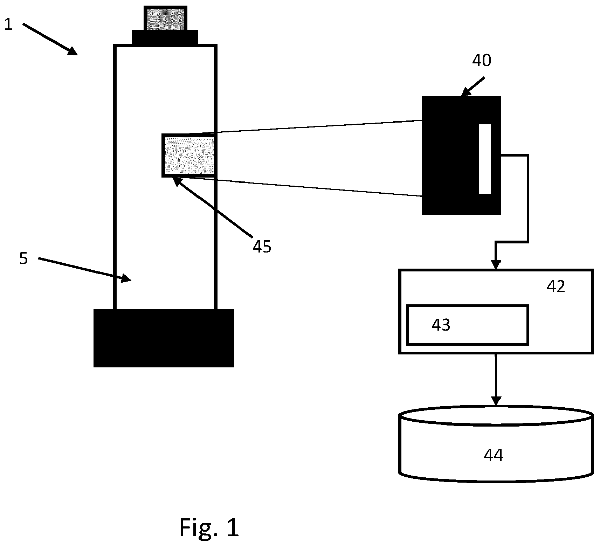

Fig. 1 is a schematic illustration of a system according for scanning the surface 5 and/or interfaces of high voltage and/or medium voltage cable components, in this example a cable end 1. The sizes of various object of the illustration are not in scale. The system comprises a non-contact surface scanner 40. The non-contact surface scanner 40 is directable to an area of interest 45.

In one embodiment, the non-contact surface scanner 40 may be a 3D laser scanner. The scanner may also be other types of non-contact surface scanners, for example white line scanners using projected white lines able to project up to 1,500,000 measurements/s and/or 99 white light scanning lines, or other kinds of suitable scanners.

The non-contact surface scanner 40 is arranged to measure the distance to the surface 5 of the area of interest. In the example in the figure, the field-of-view of the non-contact surface scanner corresponds to the area of interest, but the area of interest 45 on the surface 5 may be larger or smaller than the field-of-view or scanning area of the non-contact surface scanner 40. The field-of-view may be round, rectangular, linear or any other shape as determined by the non-contact surface scanner. The non-contact surface scanner 40 is movable around the cable 1 such that the surface 5 of the cable 1 is covered by a plurality of sub-areas in order to ensure that the entire area of interest is scanned. The size of plurality of sub-areas may vary, for example by varying the distance between the non-contact surface scanner 10 and the cable 1. In one embodiment the non-contact surface scanner 10 is freely movable in any direction around the cable 1, such as a handheld 3D laser scanner.

The non-contact surface scanner should 40 know its position and direction in 3D space, for example by recognizing a plurality of markers (not shown) positioned on the surface 5. The markers may be stickers or sterile clamps with specific patterns or markers thereon. The markers will result in "NaN" (not a number = empty) areas underneath them, however, the scan can be paused, markers/clamps relocated and then the measurement can also scan the area under the markers. In another embodiment the non-contact surface scanner 40 may be mounted to a fixture or jig, e.g. mountable to the HV-cable, such that the non-contact surface scanner 40 may be moved up/down and around the surface 5 to completely fill the area of interest 5 with sub-areas. In this way, using markers may be avoided. An example of such a jig will be described below. In other embodiments, the non-contact surface scanner 10 can be arranged in a fixture or jig, and the cable may be moved relative to the scanner 10.

In some embodiments, the geometry of the scanned surface itself may be used as reference for the position of the non-contact surface scanner 40 itself in 3D space.

The illustrated system also comprises an analysis unit 42. The analysis unit 42 is in communication with the non-contact surface scanner 40 over a wired or wireless communication link. In one embodiment, at least parts of the analysis unit 42 may be comprised in the non-contact surface scanner 40. The analysis unit 42 comprises a processor 43 adapted to process measurement data from the non-contact surface scanner 40 for each of the plurality of sub-areas to create a continuous 3D surface geometry measurement of the area of interest 45, and thus the surface to be evaluated. The continuous 3D surface geometry measurement can be processed to evaluate the characteristics of the surface and can also create an image of the surface for evaluation and for later reference.

In one embodiment, the analysis unit can provide a go/no go evaluation of the scanned cable/cable part. In this way an operator may receive a go or a no go after the scan is performed, allowing or disallowing the operator to proceed with the cable part.

The criterium for providing go/no go may be based on a selection of criterions. The criterions can be selected depending on the type of cable part to be scanned, the type of non-contact scanner used and the purpose of the scan. Examples of criterions are: a height variation threshold, a surface derivative threshold, a peeling wave threshold and/or at least one of an area of a cut, a depth of a cut, and a slope of a cut.

For laser scanners, criterions can comprise macro-geometric control, alignment and object bend, flatness, slope/macro-derivate, macro-height/indentation, ovality, size, larger Steps.

For optical profilometry, criterions can comprise derivatives, height, roughness parameters and/or local computed field enhancement factor (FEF).

Further criterions may be employed after further processing of the 3D surface geometry measurement data. Further processing can for example be levelling and sorting the data. Examples of further criterions are local derivatives, local indentation and noise level.

The analysis unit can use the above to identify the worst regions of the area of interest, such as deeper cuts, nicks, scratches, steps, for example by means of finite element method (FEM). The method can calculate local computed FEF and local computed partial discharge inception voltage (PDIV)

In one embodiment, the analysis unit 42 is adapted to transmit the continuous 3D surface geometry measurement to a storage device 44 as a 3D topographic map of the area of interest 45. The analysis unit 42 is in communication with the storage device 44 over a wired or wireless communication link. The storage device 44 may be on on-premise server or cloud server. The 3D topographic map of the surface 5 of the cable 1 on the server 44 may be accessible to users and clients for future reference of the cable system.

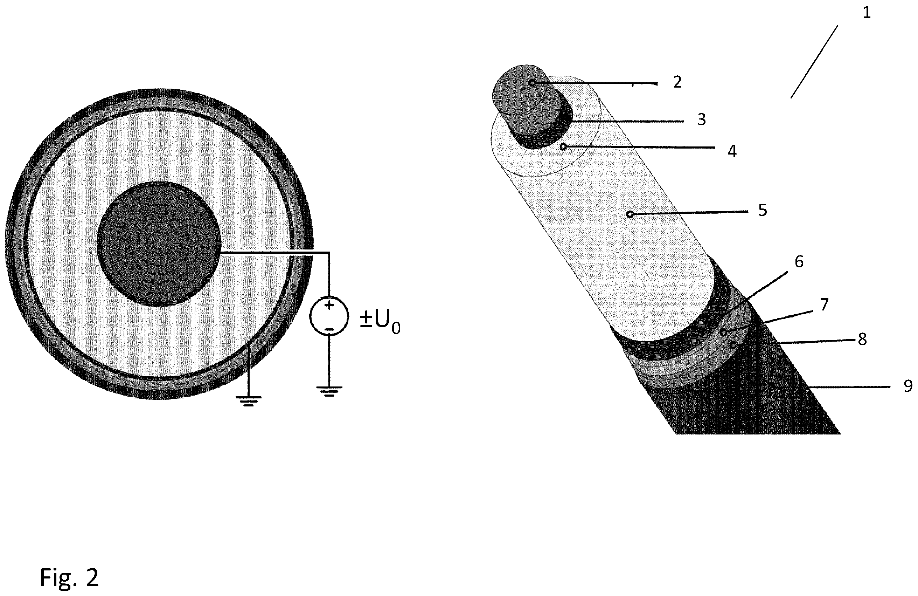

Figure 2 illustrates a detailed view of a high voltage cable end. As shown an exemplary high voltage cable end 1. The outer sheath 9, the lead sheath 8, swelling tapes 7 and the outer semiconducting screen 6 have been removed, leaving the conductor 2, the inner semiconducting screen 3 and the insulation 4. The surface 5 of the insulation 4 is inspected to ensure that there are no irregularities, before a high voltage cable accessory component, such as high voltage joint, termination for the cable, a rubber joint, is slipped over it.

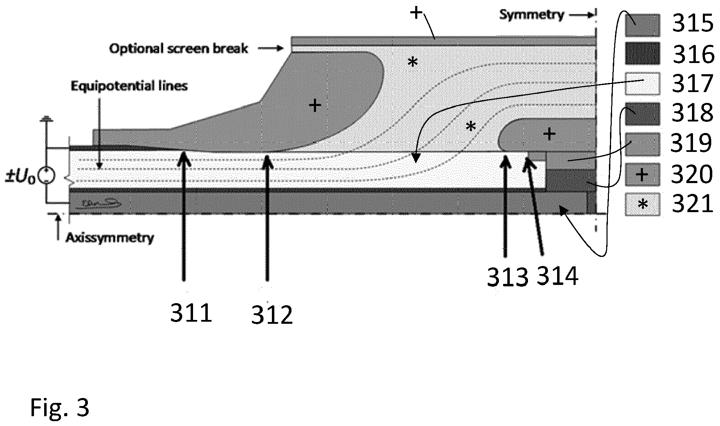

Figure 3 illustrates a high voltage joint for a high voltage cable. The figure shows different layers of the high voltage cable joint.

This example illustrates an accessory component which is a high voltage joint, which the invention can be used on. This is only an example implementation of the invention and does not limit the application of the invention only to high voltage joints.

The high voltage joint for a high voltage cable comprises a center connection 318, center shield 319, cable insulation 317, cable semiconductor 316, cable conductor 315, joint semiconductor 320, joint insulation 321, which can be seen as different layers in figure 3. The interface between each of these layers to the other layers may be a point of interest. The points of interests are also referred to as transition points as there is a transition of material from one type of material to another type of material at this point. The inside of the high voltage cable comprises in this example four transition points as 311, 312, 313 and 314, but there can be any number of transition points depending on the number of layers of the material in the cable part of interest. The four transition points in this example are between joint semiconductor and cable semiconductor 311, joint semiconductor and joint insulation 312, joint semiconductor and cable insulation 313 and joint semiconductor and center shield 314. In total, there may be eight such transition points for a high voltage joint with four points on each side of the high voltage joint. For a high voltage joint, point 311 and 314 must lie outside the interval spanned by point 312 and 313 on each side of the high voltage joint.

The identification of these transition points can be used to determine the positioning points which can be used to position of the high voltage cable joint on a cable. In an embodiment, the transition points may be identified by performing inner scans or they may be known by a pre-determined process carried out prior to performing 3-dimensional scans by the scanner 10. For example, the pre-determined process may employ dimensions from the datasheet provided for high voltage cable joints, may be measured manually and input the manual data to 3D data or an algorithm.

In another embodiment, the transition points may also be measured previously by an optical scanner, conventional scanner, 3D probe or a rotational bore type scanner.

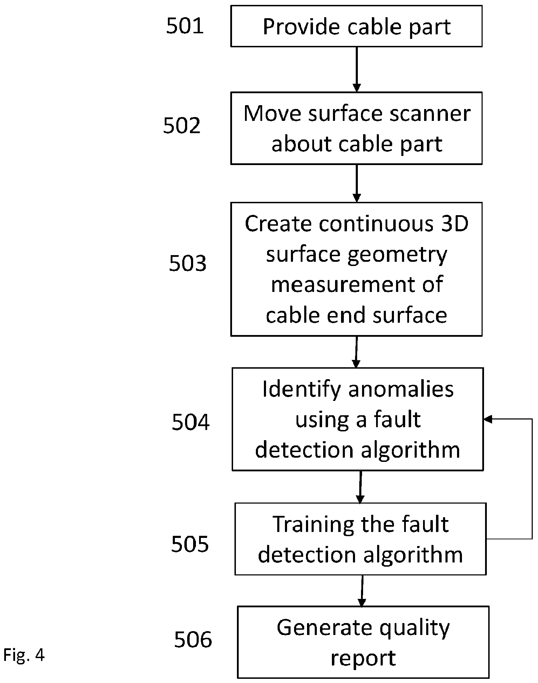

Figure 4 illustrates an embodiment of the method used on a cable end surface. The first step is 501 provide a cable part with the end surface of interest. Thereafter, in 502 the surface scanner is moved about the cable part, particularly the cable end surface. In 503, in an analysis unit, create a continuous 3D surface geometry measurement of the area of interest by processing the set of 3D surface geometry measurement data from the 3D surface scanner. The processing comprises identifying in 504 anomalies in the continuous 3D surface geometry and inspect the captured 3D surface geometry measurement data to discover sub-areas with increased probability for faults. The findings are used to generate a quality report in 506 for the cable end surface. The illustrated method further comprises training step 505, wherein a training data set is created comprising the sub-areas with increased probability for faults, and a fault detection algorithm in the analysis unit is trained using the training data set.

## Claims

1. Method for determining a quality of a surface of a cable, a part of a cable or an accessory for a cable, comprising following steps:
- capture and store a set of 3-dimensional, 3D, surface geometry measurement data of an area of interest of the surface of the cable or the part of a cable or the accessory for a cable by moving (502) a 3D surface scanner over the area of interest,
- in an analysis unit, create (503) a continuous 3D surface geometry measurement of the area of interest by processing the set of 3D surface geometry measurement data from the 3D surface scanner,
- where the processing comprises identifying (504) anomalies in the continuous 3D surface geometry and inspect the captured 3D surface geometry measurement data to discover sub-areas with increased probability for faults, and
- generate (506) a quality report for the surface scanned by the 3D surface scanner.

2. Method according to claim 1, comprising identifying locations in the continuous 3D surface geometry measurement of the area of interest lacking data and/or comprising poor quality data and using data from nearby data in interpolations to provide interpolated data and to fill in the locations lacking data and/or comprising poor quality data.

3. Method according to claim 1 or 2, comprising identifying locations in the continuous 3D surface geometry measurement of the area of interest that represent a curved cable part, and where the processing comprises using a sine or cosine function on the data representing the curved cable part to change the representation of a curved cable part to a straightened cable part.

4. Method according to one of the previous claims, comprising identifying locations in the continuous 3D surface geometry measurement of the area of interest that represent an oval cable part by using a sine or cosine function on the data.

5. Method according to one of the previous claims, comprising
- sorting the identified anomalies by evaluating the predicted consequences of each anomaly,
- processing a subset of anomalies having the worst consequences by performing a finite element simulation to compute at least one of:
- local field enhancement into the insulation of the cable or the part of a cable or the accessory for a cable,
- maximum local voids,
- partial discharge inception voltage,
and use the results of the computations to calculate probability for faults.

6. Method according to claim 5 comprising calculating local field enhancement factor, FEF, and local partial discharge inception voltage, PDIV.

7. Method according to one of the previous claims, where the method comprises
- creating a training data set comprising the sub-areas with increased probability for faults, and
- training (505) a fault detection algorithm in the analysis unit using the training data set.

8. Method according to one of the previous claims, where the area of interest is the surface of a sub-part of a cable part before assembling the cable part.

9. Method according to one of the previous claims, comprising identifying differences between the area of interest of the surface of the cable or the part of a cable or the accessory for a cable and a 3D drawing of the area of interest of the surface of the cable or the part of a cable or the accessory for a cable by comparing the continuous 3D surface geometry measurement of the area of interest with the 3D drawing of the area of interest and mark the differences in the continuous 3D surface geometry measurement to produce a deviation map.
